# EUROPÄISCHE PATENTANMELDUNG

(11) **EP 0 633 717 A1**
(43) Veröffentlichungstag der Anmeldung: **11.01.1995**
(21) Anmeldenummer: 94109156.3
(22) Anmeldetag: 15.06.1994
(51) Int. Cl.: H05K 3/34, G03F 7/40

(54) **Verfahren zur Herstellung einer lötbaren gedruckten Schaltung**

(30) Priorität: 10.07.1993 DE 4323064
(71) Anmelder: MORTON INTERNATIONAL, INC., Chicago Illinois 60606-1596 (US)
(72) Erfinder: Schütze, Gerald Dr., D-65439 Flörsheim (DE); Lingnau, Jürgen Dr., D-65130 Mainz (DE)
(74) Vertreter: Weber, Dieter, Dr.

(57) **Zusammenfassung**

Es wird eine mit einer Lötstoppmaske bildmäßig abgedeckte gedruckte Schaltung beschrieben, deren Oberfläche mit einer organischen Silylverbindung umgesetzt worden ist. Die Umsetzung mit der Silylverbindung erfolgt, nachdem die Lötstoppmaske erzeugt und ausgehärtet worden ist. Durch diese Behandlung wird die Resistenz der Schaltung gegen Korrosion durch Luftfeuchtigkeit verbessert und die Ansammlung von Lotmetallperlen und -fäden auf der Oberfläche der Maske verhindert.

## Beschreibung

Die Erfindung betrifft ein Verfahren zur Herstellung einer lötbereiten gedruckten Schaltung, bei dem man eine gedruckte Schaltung mit Leiterzügen auf einer Isolierstoffplatte herstellt und die Schaltung mit einer Lötstoppmaske abdeckt, die die gesamte Oberfläche mit Ausnahme der Lötaugen bedeckt.

Sie betrifft ferner eine mit einer Lötstoppmaske bildmäßig bis auf die Lötaugen abgedeckte gedruckte Schaltung.

Gedruckte Schaltungen der genannten Gattung und Verfahren zu ihrer Herstellung sind bekannt. Diese Schaltungen werden gewöhnlich durch Heißverzinnen ("Hot-Air-Levelling") und bzw. oder Wellenlöten - auch als Schwallöten bezeichnet - oder durch Reflexlöten, Dampfphasenlöten oder Laserlöten, ggf. nach Bestücken mit Bauteilen, weiterverarbeitet.

Die Lötstoppmasken werden gewöhnlich wegen der besseren Löteigenschaften der mit ihnen ausgerüsteten Platinen und wegen der höheren Auflösung im Vergleich zu Masken, die durch Siebdruck hergestellt worden sind, bevorzugt durch Photoresisttechnik, d. h. durch bildmäßiges Belichten und nachfolgendes Auswaschen der nicht benötigten Schichtbereiche, hergestellt. Aus ökologischen Gründen werden dabei lichtempfindliche Mischungen bevorzugt, die sich mit wäßrigen, z. B. wäßrig-alkalischen Lösungen entwickeln lassen und hierfür keine organischen Lösemittel, z. B. chlorierte Kohlenwasserstoffe, erfordern. Lichtempfindliche Schichten dieser Art weisen jedoch eine höhere Hydrophilie auf, die besonders unter ungünstigen klimatischen Bedingungen, z. B. bei höherer Umgebungstemperatur und/oder erhöhter Luftfeuchte, die Tendenz der Leiterbahnen zur Korrosion erhöhen. Auch wird das Lotmetall von solchen hydrophilen Schichten weniger leicht abgewiesen, was sich in der Ausbildung von kleineren oder größeren Lotperlen oder -fäden, sog. "Lotspinnweben", auf der Oberfläche der Lötstoppmaske äußert.

Ein Verfahren zur Beseitigung des letztgenannten Nachteils ist in der EP-A 105 421 beschrieben und besteht darin, daß man der Oberfläche der lichtempfindlichen Schicht durch Prägen mit einer Folie mit rauher Oberfläche eine rauhe Struktur verleiht. Dieses Verfahren eignet sich gut für Lötstoppmaterialien, die im Trockenphotoresistverfahren, also durch Laminieren unter Druck und erhöhter Temperatur, auf die Schaltungsoberfläche aufgebracht werden. Bei Lötstoppmasken, die aus Lösung aufgebracht werden, ist es weniger geeignet; auch wird dadurch die Hydrophilie der Oberfläche nicht verändert.

Aufgabe der Erfindung war es, eine Lötstoppmaske bereitzustellen, die sich im Trocken- oder Flüssigresistverfahren aufbringen und mit wäßrigen Lösungen verarbeiten läßt, die die Korrosion damit abgedeckter Leiterzüge besser verhindert und deren Oberfläche eine geringere Neigung zur Ansammlung von Lotperlen oder -fäden aufweist als bekannte Masken dieser Art.

Erfindungsgemäß wird eine mit einer Lötstoppmaske bildmäßig abgedeckte gedruckte Schaltung vorgeschlagen, die dadurch gekennzeichnet ist, daß die Oberfläche der Lötstoppmaske durch Behandeln mit einer organischen Silylverbindung umgesetzt worden ist.

Erfindungsgemäß wird ferner ein Verfahren zur Herstellung einer lötbereiten gedruckten Schaltung vorgeschlagen, bei dem man eine gedruckte Schaltung mit Leiterzügen auf einer Isolierstoffplatte herstellt, die Schaltung mit einer Lötstoppmaske unter Aussparung der Lötaugen bedeckt. Das erfindungsgemäße Verfahren ist dadurch geKennzeichnet, daß man die Oberfläche der Lötstoppmaske mit einem Silylierungsmittel behandelt.

Die Silylierung wird bevorzugt bei erhöhter Temperatur, insbesondere bei einer Temperatur im Bereich von 60 - 180 °C durchgeführt. Sie wird vorteilhaft unter vermindertem Druck, vorzugsweise unterhalb von 200 mbar durchgeführt.

Als Silylierungsmittel ist grundsätzlich jede reaktionsfähige Silylverbindung geeignet, die mit den Bestandteilen der gehärteten Lötstoppmaske zu reagieren vermag. Beispiele für Silylverbindungen sind Silylhalogenide und insbesondere Silazane. Diese haben u. a. den Vorteil, daß bei ihrer Umsetzung Ammoniak entsteht, das eine zusätzliche vernetzende Wirkung auf die in der Schicht enthaltene Epoxyverbindung hat.

Die Silylierung der Oberfläche erfolgt nach der Herstellung und Aushärtung der Lötstoppmaske. Wenn ein mehrstufiger Lötprozeß, z. B. aus Heißverzinnen und Wellenlöten, durchgeführt wird, kann die Silylierung vor oder nach der ersten Stufe erfolgen. Wenn die Oberfläche der Schaltung noch mit Bauteilen bestückt (Service-Mount-Device ("SMD")-Kleber) oder mit Kennzeichnungsdrucken versehen werden soll, kann die Silylierung auch nach diesen Stufen erfolgen, um mögliche Haftungsschwierigkeiten zu vermeiden.

Durch die erfindungsgemäße Behandlung wird die Oberfläche der Lötstoppmaske wasserabweisend und unpolar. Dadurch wird das Anhaften von Lotresten wirksam vermieden, auch wenn man feststoffarme Flußmittel (Fluxer), z. B. beim Löten unter Stickstoff, einsetzt. Gegebenenfalls kann sogar auf den Einsatz von Fluxern ganz verzichtet werden, wodurch man die damit verbundenen Reinigungsprobleme vermeiden kann.

Die Herstellung und Zusammensetzung von Lötstoppmasken, wie sie erfindungsgemäß durch Silylierung modifiziert werden, ist z. B. in den EP-A 418 733 und 549 946 beschrieben. Die dort beschriebenen, zur Herstellung der Lötstoppmasken eingesetzten lichtempfindlichen Gemische enthalten
a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches polymeres Bindemittel,
c) ein feinteiliges mineralisches Pigment auf Kieselsäure- bzw. Silikatbasis,
d) einen durch Strahlung aktivierbaren Polymerisationsinitiator oder eine Polymerisationsinitiatorkombination.
e) eine Verbindung, die mit sich selbst, mit dem Bindemittel (b) oder mit dem Polymerisat der Verbindung (a) in der Wärme zu vernetzen vermag und
f) ggf. einen durch Wärme aktivierbaren Vernetzungsinitiator für die Verbindung (e).

Die Oberfläche des Pigments (c) kann, wie in der EP-A 549 946 beschrieben, durch Umsetzen mit einer damit reaktiven Verbindung modifiziert sein, die zusätzlich eine radikalisch oder thermisch vernetzbare Gruppe enthält. Diese reaktive Verbindung kann z. B. ein Alkoxysilan oder Chlorsilan sein, das Epoxy- oder (Meth)acryloylgruppen enthält. Der Mengenanteil des Pigments beträgt im allgemeinen etwa 20 bis 50, vorzugsweise 20 bis 40 Gew.-%.

Die Oberflächenbehandlung der Pigmente erfolgt in bekannter Weise. Geeignete Behandlungsverfahren sind in den DE-A 33 25 064, 36 11 999, der DE-B 23 04 602 und dem Artikel "Silanbehandelte Füllstoffe und deren Verwendung in der Farbenindustrie" von Hofmann und Merzbach in Coating, 1990, S. 348-350 beschrieben.

Als polymerisierbare Verbindungen werden im allgemeinen Ester der Acryl- oder Methacrylsäure mit mehrwertigen, vorzugsweise primären, Alkoholen verwendet.

Der Alkohol sollte mindestens zwei Hydroxygruppen enthalten, da durch mehrfach ungesättigte Verbindungen die erwünschte Vernetzungswirkung erreicht wird. Bevorzugt werden mindestens zweifach ungesättigte Verbindungen; es können aber auch einfach ungesättigte, z. B. Ester von einwertigen Alkoholen, im Gemisch enthalten sein. Beispiele für geeignete mehrwertige Alkohole sind Ethylenglykol, Propylenglykol, Butandiol-1,4, Diethylenglykol, Triethylenglykol, Oligopropylenglykole, Trimethylolethan und -propan, Pentaerythrit, Dipentaerythrit, Bisphenol-A-bis-hydroxyethylether. Es sind ferner die niedermolekularen, Urethangruppen enthaltenden Bis-acrylate und Bis-methacrylate geeignet, die durch Umsetzen von 2 mol Hydroxyalkylacrylat oder -methacrylat mit 1 mol eines aliphatischen oder cycloaliphatischen Diisocyanats, z. B. 2,2,4-Trimethyl-hexamethylendiisocyanat, erhalten werden. Derartige Urethangruppen enthaltende Monomere sind in der US-A 4 088 498 beschrieben. Besonders vorteilhaft sind Acrylate und Methacrylate, insbesondere Acrylate, mit hohem Doppelbindungsgehalt. So werden Monomere mit 3 oder mehr ungesättigten Gruppen bevorzugt. Auch sind im allgemeinen Ester, die noch mindestens eine freie Hydroxygruppe enthalten, den vollständig veresterten Verbindungen überlegen. Die Ester des Trimethylolpropans, Trimethylolethans, des Pentaerythrits und Dipentaerythrits werden besonders bevorzugt. Das Monomere ist im allgemeinen in einer Menge von 10 bis 35, vorzugsweise von 15 bis 30 Gew.-%, bezogen auf den Gesamtgehalt an nichtflüchtigen Bestandteilen, in dem Gemisch enthalten.

Wesentlich für die Brauchbarkeit des Gemischs ist das polymere Bindemittel. Es ist in Wasser unlöslich und bevorzugt in wäßrig-alkalischen Lösungen löslich. Hierzu eignen sich vor allem Polymere mit seitenständigen Carboxyl- oder Carbonsäureanhydridgruppen. Besonders bevorzugt werden Copolymere der Acryl- und Methacrylsäure, die als Comonomere Acryl- oder Methacrylsäureester, Styrole, Acryl- oder Methacryinitril, Acryl- oder Methacrylamid oder Vinylheterocyclen enthalten. Als (Meth)acrylsäureester werden Alkylester mit vorzugsweise 1 bis 10, insbesondere 1 bis 7 Kohlenstoffatomen, in der Alkylgruppe eingesetzt. Das Styrol kann ein o-, m- oder p-Vinyltoluol, ein Vinylethylbenzol, das α-Methyl- oder α-Chlorstyrol, ein o-, m- oder p-Chlorstyrol, ein Vinylanisol oder dgl. sein. Das unsubstituierte Styrol wird im allgemeinen bevorzugt. Der Mengenanteil an Styroleinheiten liegt im Bereich von 40 bis 65, vorzugsweise von 45 bis 60 Gew.-%; der des (Meth)acrylsäureesters bei 5 bis 40, vorzugsweise zwischen 5 und 25 Gew.-%. Die (Meth)acrylsäureeinheiten sollten in solcher Menge vorliegen, daß die Säurezahl des Polymeren im Bereich von 110 bis 280, vorzugsweise von 125 bis 260 liegt. Der Mengenanteil des Polymeren im Gemisch beträgt im allgemeinen 15 bis 50, vorzugsweise 20 bis 35 Gew.-%.

Als durch Strahlung aktivierbare Polymerisationsinitiatoren können zahlreiche Substanzen Verwendung finden. Beispiele sind Benzoine, Benzoinether, Mehrkernchinone, wie 2-Ethylanthrachinon, Acridinderivate, wie 9-Phenylacridin oder Benzacridine, Phenazinderivate, wie 9,10-Dimethylbenz(a)phenazin, Chinoxalin- oder Chinolinderivate, wie 2,3-Bis-(4-methoxyphenyl)chinoxalin oder 2-Styrylchinolin, Chinazolinverbindungen oder Acylphosphinoxidverbindungen. Photoinitiatoren dieser Art sind in den DE-C 20 27 467, 20 39 861, der DE-A 37 28 168, der EP-B 11 786 und der EP-A 220 589 beschrieben. Außerdem können z. B. Hydrazone, Mercaptoverbindungen, Pyrylium- oder Thiopyryliumsalze, Xanthone, Thioxanthone, Benzochinone, Acetophenone, Benzophenone, synergistische Mischungen mit Ketonen oder Hydroxyketonen und Farbstoff-Redoxsysteme eingesetzt werden. Besonders bevorzugt werden Photoinitiatoren, die durch Licht spaltbare Trihalogenmethylgruppen aufweisen, wobei insbesondere entsprechende Verbindungen aus der Triazin- oder Thiazolinreihe erwähnt sein sollen. Solche Verbindungen sind in den DE-A 27 18 259, 33 33 450 und 33 37 024 beschrieben. Ein bevorzugtes Beispiel ist 2-(4-Methoxystyryl)4,6-bis-trichlormethyl-s-triazin.

Die Photoinitiatoren werden im allgemeinen in Mengenanteilen von 0,1 bis 15, vorzugsweise von 0,5 bis 10 Gew.-%, bezogen auf die nichtflüchtigen Bestandteile des Gemischs, zugesetzt.

Das Gemisch enthält ferner eine thermisch vernetzbare Verbindung. Bevorzugt werden zwei- oder mehrwertige Epoxyverbindungen. Als Beispiele sind insbesondere Bisglycidylether von zweiwertigen Alkoholen und Phenolen, z. B. von Bisphenol A, von Polyethylenglykol- und Polypropylenglykolethern des Bisphenols A, von Butan-1,4-diol, Hexan-1,6-diol, Polyethylenglykol, Polypropylenglykol oder Polytetrahydrofuran geeignet.

Auch Bisglycidylether von dreiwertigen Alkoholen, z. B. von Glycerin, können verwendet werden. Die Epoxide werden dem Gemisch gewöhnlich in einer Menge von etwa 10 bis 30, vorzugsweise 12 bis 25 Gew.-%, bezogen auf die nichtflüchtigen Bestandteile des Gemisches, zugesetzt.

Bevorzugte Bisepoxide sind in der EP-A 418 733 beschrieben.

Als weitere thermisch vernetzbare Verbindungen sind solche mit kondensationsfähigen N-Hydroxymethyl- oder N-Alkoxymethylgruppen geeignet. Beispiele sind Hexamethoxymethyl- und Hexahydroxymethylmelamin.

Wenn als Vernetzer Epoxyverbindungen eingesetzt werden, enthält das Gemisch bevorzugt einen Härter oder Additionsinitiator für Epoxygruppen. Der Härter ist bevorzugt eine Stickstoffbase, z. B. Triethylamin, 1,4-Diazabicyclo[2.2.2]octan (Dabco), Dibutylamin, höher alkylierte Mono-, Di- und Triamine auf aliphatischer Basis, ferner aliphatisch-aromatische Amine wie z. B. Dimethylanilin. Die tertiären, insbesondere aliphatischen Amine werden bevorzugt. Ganz besonders bevorzugt wird das Diazabicyclooctan. Die Menge der Base liegt im allgemeinen zwischen 0,15 und 1,5, vorzugsweise zwischen 0,2 und 1,0 Gew.-%.

Vorzugsweise enthält das Gemisch mindestens einen Farbstoff, um die entwickelte Resistschablone besser sichtbar zu machen. Dabei wird mit Vorteil eine Kombination von mindestens zwei Farbstoffen verwendet, von denen der eine bei Bestrahlung seine Farbe ändert und bei Temperaturen oberhalb 200 °C zerstört, d. h. farblos wird. Der andere Farbstoff soll sowohl die Bestrahlung als auch Temperaturen oberhalb 200 °C ohne Veränderung überstehen. Er soll die Lötstoppmaske während des Lötens und danach deutlich sichtbar machen. Hierfür geeignete Farbstoffe sind in der DE-A 3 114 931 beschrieben.

Das Gemisch kann gegebenenfalls eine Reihe weiterer üblicher Zusätze enthalten, z. B. Inhibitoren zur Verhinderung der thermischen Polymerisation der Monomeren, Wasserstoffdonatoren, Lichtempfindlichkeitsregler, Pigmente, Weichmacher und Thixotropiermittel, insbesondere mineralische, ggf. hydrophobierte Pigmente, wie SiO₂, oder organische Polymere, wie Polyacrylamide. Thixotropiermittel sind z. B. beim Antrag durch Vorhanggießen oder durch vertikalen Siebdruck sehr von Vorteil.

Die Verarbeitung des lichtempfindlichen Gemischs erfolgt in bekannter Weise, z. B. im Siebantrag. Das gelöste bzw. dispergierte Gemisch wird z. B. durch ein in einem Metallrahmen gespanntes Siebgewebe von 34 bis 55 Maschen je cm mit einer Rakel auf das Leiterplattenobjekt aufgebracht. Eine andere Möglichkeit ist die Vorhangbeschichtung. Mit Hilfe einer handelsüblichen Vorhanggießmaschine wird ein kontinuierlich vertikal laufender Flüssigkeitsfilm erzeugt. Mittels eines Förderbandes wird die Leiterplatte unter diesem Film durchgeführt und damit beschichtet. Das Gemisch kann schließlich auch über eine Sprühbeschichtung, vorzugsweise eine elektrostatische Sprühbeschichtung, aufgebracht werden. In einer geschlossenen Kabine wird die Lösung an einem Sprühkopf in feinste Tröpfchen zerteilt, diese durch Hochspannung elektrostatisch aufgeladen und auf der Leiterplatte abgeschieden. Auch im Tauchziehverfahren, durch Walzenantrag und durch Luftdrucksprühen lassen sich die Mischungen verarbeiten.

Die nach einem der geschilderten Verfahren verarbeiteten Beschichtungsgemische werden durch Trocknen im Umlufttrockenschrank und bzw. oder unter einem IR-Trockner vom Lösemittel befreit. Die so beschichtete Leiterplatte wird dann durch eine Vorlage belichtet, die die Teile der Platte vor der Bestrahlung schützt, die für den Lötvorgang freibleiben müssen.

Als aktinische Strahlung, gegenüber der das erfindungsgemäße Gemisch empfindlich ist, kommt jede elektromagnetische Strahlung in Betracht, deren Energie zur Anregung eines geeigneten Polymerisationsinitiators ausreicht. Geeignet ist insbesondere sichtbares und ultraviolettes Licht, Röntgen-, γ- und Elektronenstrahlung. Auch Laserstrahlung im sichtbaren und UV-Bereich kann verwendet werden. Bevorzugt wird kurzwelliges sichtbares und nahes UV-Licht.

Entwickelt werden die Schichten in bekannter Weise. Als Entwickler für die bevorzugten Schichten sind wäßrige, vorzugsweise wäßrig-alkalische Lösungen, z. B. von Alkaliphosphaten, -carbonaten oder -silikaten, geeignet, denen gegebenenfalls kleine Mengen, z. B. bis zu 10 Gew.-%, an mit Wasser mischbaren organischen Lösemitteln oder Netzmitteln zugesetzt werden können.

Die fertig entwickelten Lötmasken werden dann einer Temperaturbehandlung unterzogen. Dabei reagieren z. B. die Carboxylgruppen des Bindemittels mit dem mehrfunktionellen Epoxid zu einem interpenetrierenden Netzwerk. Diese thermische Behandlung erfolgt im allgemeinen zwischen 80 °C und 180 °C, bei ungefähren Behandlungszeiten von 10 bis 90 Minuten. Die lötbereite Platte kann dann mit elektronischen Bauelementen in bekannter Weise bestückt werden.

Nach diesen Behandlungsschritten kann sich die Silylierung anschließen. Die Behandlung erfolgt bevorzugt mit einem Silazan, das im allgemeinen bei erhöhter Temperatur, vorzugsweise im Bereich von 60 bis 180 °C einwirken gelassen wird. Die Einwirkung wird vorteilhaft unter vermindertem Druck, z. B. bei Drucken unterhalb 200 mbar, durchgeführt. Vor der Silazanbehandlung wird die zu behandelnde Oberfläche zweckmäßig durch Evakuieren und Spülen mit bis zu 180 °C heißem Stickstoff von Sauerstoff und Feuchtigkeit befreit. Nach der Einwirkung des Silazans kann dessen Überschuß durch ein- oder mehrmaliges Evakuieren und Spülen mit Stickstoff entfernt werden.

Wenn ein zweistufiger Lötprozeß aus Heißluftverzinnen und Wellenlöten durchgeführt werden soll, kann die Silylierung auch nach der ersten Stufe, die bevorzugt aus Heißluftverzinnen besteht, vorgenommen werden. Zwischen beiden Lötstufen kann die behandelte Oberfläche in bekannter Weise durch Aufsprühen von Wasser unter hohem Druck gereinigt werden.

Die Lötprozesse erfolgen in bekannter Weise, wie sie in der EP-A 549 946 beschrieben sind.

Durch die erfindungsgemäße Behandlung mit Silylierungsmitteln wird die Oberfläche der Lötstoppmaske dauerhaft hydrophobiert. Das wirkt sich u. a. darin aus, daß das Lotmetall die Oberfläche nicht benetzt und von dieser vollständig abperlt. Dadurch werden die bekannten Probleme der "Lotspinnweben" wirksam vermieden. Außerdem wird die Oberfläche durch die Hydrophobierung wasserabweisend, so daß beim Lagern der Schaltung in feuchter Atmosphäre keine Feuchtigkeit in die Maske eindringen kann. Auf diese Weise wird eine Korrosion der darunterliegenden Kupferleiterzüge auch bei längerer Lagerung wirksam verhindert.

Die folgenden Beispiele erläutern einzelne Ausführungsformen des erfindungsgemäßen Verfahrens. Wenn nichts anderes angegeben ist, sind Prozentzahlen und Mengenverhältnisse in Gewichtseinheiten zu verstehen. Gewichtsteile (Gt) und Volumenteile (Vt) stehen im Verhältnis von g zu ml.

### Beispiel 1 (Vergleichsbeispiel)

### Herstellung einer verarbeitungsfertigen Lötstoppmaske

a) 275 Gt Styrol, 175 Gt Methacrylsäure, 50 Gt n-Hexylmethacrylat und 15 Gt 2,2-Azo-bis-isobuttersäurenitril wurden unter Rühren in 500 Gt 3-Methoxy-butanol-1 gelöst. 1/3 dieser Lösung wurde in einem Rundkolben unter Rühren und Hindurchleiten von Stickstoff auf 90 °C erwärmt. Die einsetzende exotherme Polymerisation wurde durch äußere Kühlung bei 90 °C bis maximal 100 °C gehalten. Nach Abklingen der Hauptreaktion wurden die zurückbehaltenen 2/3 der Lösung innerhalb 1 1/2 Stunden gleichmäßig zudosiert und anschließend die Reaktionslösung noch 12 bis 14 Stunden bei 90 °C gehalten. Die Polymerlösung war nach Abkühlen auf Zimmertemperatur gebrauchsfertig.
   Die reduzierte spezifische Viskosität des Produkts betrug 0,185 dl/g (gemessen an einer 1 %igen Lösung in Dimethylformamid bei 25 °C).
b) In einem zylindrischen Gefäß wurden in 123,9 Gt 3-Methoxy-butanol-1
   112,5 Gt Pentaerythrit-triacrylat,
   128,9 Gt Trimethylolpropan-triacrylat,
   27,5 Gt 9-Phenylacridin,
   12,4 Gt Neozapongrün,
   1,2 Gt eines blauen Azofarbstoffs, erhalten durch Kuppeln von 2,4-Dinitro-6-chlor-benzol-diazoniumsalz mit 2-Methoxy-5-acetylamino-N,N-diethylanilin und
   2,5 Gt Triethylendiamin

mit einem hochtourigen Schnellrührer in Lösung gebracht. Dann wurden im Verlauf von 30 Minuten 396,7 Gt eines silikatischen Pigments, das ein natürliches Agglomerat von korpuskularem Quarz und laminarem Kaolinit ist, in die gerührte Lösung eingestreut. Es enthält über 80 % SiO₂ und ca. 11 % Al₂O₃; ca. 90 Gew.-% der Teilchen haben eine Korngröße unterhalb 5 µm (Sillitin). Dieser Suspension wurden anschließend 694,2 Gt der unter a) beschriebenen Polymerlösung zugesetzt. Der nun mit allen Komponenten versehene Ansatz wurde mit Hilfe des Mischers gut homogenisiert (1.200 U/min), wobei darauf geachtet wurde, daß die Temperatur des Ansatzes nicht über 50 bis 55 °C anstieg.

Der viskose Lack wurde zur weiteren Homogenisierung in einer Glaskugelmühle vermahlen und dann durch ein 160 µm V2A-Gewebe-Druckfilter filtriert und abgefüllt. Diese Mischung wurde, soweit erforderlich, mit Methoxybutanol auf eine Viskosität von 225 dPas verdünnt und im Folgenden als Komponente A bezeichnet.
c) In einem zylindrischen Gefäß wurden 280 Gt eines epoxydierten Phenol-Formaldehyd-Harzes mit dem Epoxid-Äquivalentgewicht 172 bis 179 in 120 Gt 3-Methoxybutanol mittels eines Ankerrührers gelöst. Nach 15 Minuten Rührzeit lag eine klare Lösung mit 70 % Feststoffgehalt vor. Diese Lösung wurde im Folgenden als Komponente B bezeichnet.
d) 100 Gt der Komponente A wurden mit 20,4 Gt der Komponente B mit einem passenden Rührer intensiv gemischt. Damit war die Lötstopplösung zum Gebrauch, also zum Antrag auf eine Leiterplatte nach einem der oben erwähnten Verfahren, fertig. Der Feststoffgehalt betrug 69,8 %.
e) Eine 24 x 36 cm große Platte aus Epoxidharz-Glas-gewebe mit einem beidseitig aufgebrachten Schaltbild aus 0,2 bis 1,5 mm breiten und 50 bis 90 µm dicken Kupferbahnen und durchkontaktierten Bohrungen wurde mit der unter d) beschriebenen Lösung mittels einer halbautomatischen Siebdruckmaschine (Alfra-Plan 50/70) vollflächig beschichtet. Zur Lackübertragung wurde ein vollflächig offenes Polyestersieb mit 34 Maschen je cm verwendet; die Gummirakel mit einer Härte von 70 Shore war an der Druckkante leicht abgerundet, und der Antragswinkel betrug 15°. Auf diese Weise ließen sich blasen- und farbschattenfreie Beschichtungen mit einer Flankenabdeckung von 15 bis 20 µm erzielen. Die so beschichtete Leiterplatte wurde 5 Minuten bei Raumtemperatur belassen und anschließend 7 Minuten in einem Umlufttrockenschrank bei 80 °C getrocknet. Nach dem Abkühlen auf Raumtemperatur wurde die beschichtete Leiterplatte durch eine Filmvorlage bildmäßig belichtet.

Entwickelt wurde in einer Durchlaufsprühanlage mit 1 %iger wäßriger Sodalösung bei 30 °C mit 1,2 bar Sprühdruck. Die Entwicklungszeit betrug 90 s; die unbelichteten Schichtbereiche waren bereits nach etwa 2/3 der Entwicklerstrecke frei entwickelt.

Nach Waschen mit Wasser wurde die entwickelte Platte in einem Warmluftdurchlauftrockner getrocknet und anschließend in einem Umlufttrockenofen 1 Stunde bei 150 °C getempert. Mit der nun vollständig ausgehärteten Platine wurde eine Heißluftverzinnung ("Hot-Air-Levelling") durchgeführt. Dazu wurde die Platine mittels Gummiwalzen mit einem wasserlöslichen Flußmittel (Robertson SM 287) benetzt und durch Eintauchen in flüssiges Lot und anschließendes Abblasen mit heißer Luft verzinnt. Die Lottemperatur betrug 250 °C, die Temperatur der an den beiden Luftmessern mit hohem Druck austretenden Luft 260 °C, die Eintauchzeit war auf 5 s eingestellt.

Die Platte wurde durch Besprühen mit Leitungswasser bei 15 bar gespült und dann wellengelötet.

Das Löten wurde auf einer Wellen-Lötmaschine durchgeführt. Dazu wurde die Platte über einen vorgeschalteten Schaumfluxer (Alphagrillo^{(R)} SM 2010) geführt, vorgetrocknet und über das aus eutektischer Blei/Zinnlegierung bestehende flüssige Lot gefahren. Die Geschwindigkeit betrug 0,9 m je Minute, die Lottemperatur 260 °C. Die Platte wurde inspiziert, und die Anzahl der Lötperlen einer Größe unterhalb 200 µm sowie einer Größe oberhalb 200 µm wurde bestimmt.

### Beispiel 2 (Vergleichsbeispiel)

Wie in Beispiel 1 beschrieben, wurde eine strukturierte Leiterplatte mit einer Lötstoppmaske versehen. In diesem Beispiel wurden aber der fertigen Beschichtungslösung noch zusätzlich 3 %, bezogen auf das Gewicht der Lösung, eines gefällten Silikatpigments mit einer mittleren Teilchengröße von ungefähr 10 µm zugesetzt, dessen Oberfläche mit einem oxydierten Polyethylenwachs beschichtet war (Crossfield HP 220). Die Oberfläche der Lötstoppmaske zeigte nach dem Trocknen eine visuell erkennbare Mattierung. Die Verarbeitung erfolgte wie in Beispiel 1 beschrieben.

### Beispiel 3

Es wurde wie in Beispiel 1 gearbeitet, jedoch wurde nach dem Heißluftverzinnen und Spülen mit Hochdruckwasser die Oberfläche der Lötstoppmaske mit Hexamethyldisilazan wie folgt behandelt:
Bei 128 °C wurde die Platte 1 Minute unter Vakuum gehalten dann 3 Minuten mit Stickstoff behandelt, und diese beiden Schritte wurden noch je zweimal wiederholt. Danach wurde bei der gleichen Temperatur 2 Minuten Vakuum angelegt, 5 Minuten mit gasförmigem Hexamethyldisilazan behandelt, wieder 1 Minute unter Vakuum gehalten, 2 Minuten mit Stickstoff begast, nochmals 2 Minuten im Vakuum gehalten und mit Stickstoff bis auf Atmosphärendruck entspannt. Die Behandlung erfolgte in einer handelsüblichen Apparatur, wie sie zur automatischen Silanierung von Wafern in der Mikroelektronik gebräuchlich ist. Nach dieser Behandlung wurde die Platte wie in Beispiel 1 beschrieben wellengelötet.

### Beispiel 4

Es wurde wie in Beispiel 3 gearbeitet, jedoch wurde die Behandlung mit Hexamethyldisilazan vor dem Heißluftverzinnen durchgeführt.

### Beispiel 5

Es wurde wie in Beispiel 4 gearbeitet, jedoch wurde die Spülung mit Hochdruckwasser nach dem Heißluftverzinnen fortgelassen.

### Beispiel 6

Es wurde wie in Beispiel 2 gearbeitet, jedoch wurde die Oberfläche der Lötstoppmaske nach dem Heißluftverzinnen und Hochdruckspülen mit Hexamethylsilazan in der in Beispiel 3 beschriebenen Weise behandelt.

### Beispiel 7

Es wurde wie in Beispiel 6 gearbeitet, jedoch wurde die Behandlung mit Hexamethyldisilazan vor dem Heißluftverzinnen durchgeführt.

### Beispiel 8

Es wurde wie in Beispiel 7 gearbeitet, jedoch wurde die Spülung mit Hochdruckwasser fortgelassen.

Die folgende Tabelle zeigt die Ergebnisse, die mit den Platten der einzelnen Beispiele erhalten wurden. Jedes Beispiel wurde mit einer Anzahl Platten wiederholt. Dabei wurde die Anzahl der Lötperlen je Platte einer Größe unterhalb 200 µm und oberhalb 200 µm ermittelt und jeweils der Durchschnittswert für alle Platten eines Beispiels angegeben.

**Tabelle**

| Beispiel | Anzahl Lotperlen < 200 µm | Anzahl Lotperlen > 200 µm |
|---|---|---|
| 1 (V) | 14 | 9 |
| 2 (V) | 3 | 2 |
| 3 | 0 | 0 |
| 4 | 0,05 | 0,1 |
| 5 | 0 | 0 |
| 6 | 0 | 0 |
| 7 | 1,3 | 0 |
| 8 | 0,8 | 0,05 |

## Patentansprüche

1. Mit einer Lötstoppmaske bildmäßig abgedeckte gedruckte Schaltung, dadurch gekennzeichnet, daß die Oberfläche der Lötstoppmaske mit einer organischen Silylverbindung umgesetzt worden ist.

2. Gedruckte Schaltung nach Anspruch 1, dadurch gekennzeichnet, daß die Silylverbindung ein Silazan ist.

3. Gedruckte Schaltung nach Anspruch 1, dadurch gekennzeichnet, daß die Lötstoppmaske die Oberfläche der Schaltung mit Ausnahme der Lötaugen bedeckt.

4. Gedruckte Schaltung nach Anspruch 1, dadurch gekennzeichnet, daß die Lötstoppmaske aus einer lichtgehärteten Schicht besteht, die durch Belichten und Entwickeln aus einer photopolymerisierbaren Schicht entstanden ist, die
a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches polymeres Bindemittel,
c) ein feinteiliges mineralisches Pigment auf Kieselsäure- bzw. Silikatbasis,
d) einen durch Strahlung aktivierbaren Polymerisationsinitiator oder eine Polymerisationsinitiatorkombination,
e) eine Verbindung, die mit sich selbst, mit dem Bindemittel (b) oder mit dem Polymerisat der Verbindung (a) in der Wärme zu vernetzen vermag, und
f) ggf. einen durch Wärme aktivierbaren Vernetzungsinitiator für die Verbindung (e) enthält.

5. Gedruckte Schaltung nach Anspruch 4, dadurch gekennzeichnet, daß die polymerisierbare Verbindung (a) ein Acryl- oder Methacrylsäureester eines aliphatischen Alkohols ist.

6. Gedruckte Schaltung nach Anspruch 4, dadurch gekennzeichnet, daß die vernetzungsfähige Verbindung (e) ein mehrfunktionelles Epoxid oder eine Verbindung mit N-Hydroxymethyl- oder N-Alkoxymethylgruppen ist.

7. Verfahren zur Herstellung einer lötbereiten gedruckten Schaltung, bei dem man eine gedruckte Schaltung mit Leiterzügen auf einer Isolierstoffplatte herstellt und die Schaltung mit einer Lötstoppmaske unter Aussparung der Lötaugen bedeckt, dadurch gekennzeichnet, daß man die Oberfläche der Lötstoppmaske mit einem Silylierungsmittel behandelt.

8. Verfahren nach Anspruch 7, dadurch gekennzeichnet, daß man die Silylierung bei einer Temperatur im Bereich von 60 bis 180 °C durchführt.

9. Verfahren nach Anspruch 7, dadurch gekennzeichnet. daß man die Silylierung unter vermindertem Druck durchführt.

10. Verfahren nach Anspruch 7, dadurch gekennzeichnet, daß man die Lötstoppmaske herstellt; indem man ein photopolymerisierbares Gemisch, das
a) eine Verbindung mit mindestens einer endständigen ethylenisch ungesättigten Gruppe, die durch radikalisch initiierte Additionskettenpolymerisation ein vernetztes Polymerisat zu bilden vermag,
b) ein wasserunlösliches, in wäßrig-alkalischen Lösungen lösliches polymeres Bindemittel,
c) ein feinteiliges mineralisches Pigment auf Kieselsäure- bzw. Silikatbasis,
d) einen durch Strahlung aktivierbaren Polymerisationsinitiator oder eine Polymerisationsinitiatorkombination,
e) eine Verbindung, die mit sich selbst, mit dem Bindemittel (b) oder mit dem Polymerisat der Verbindung (a) in der Wärme zu vernetzen vermag und
f) ggf. einen durch Wärme aktivierbaren Vernetzungsinitiator für die Verbindung (e) enthält,
auf die Oberfläche der gedruckten Schaltung derart aufbringt, daß alle Leiterzüge davon bedeckt sind, die erhaltene photopolymerisierbare Schicht unter Aussparung der Lötaugen belichtet, die unbelichteten Schichtbereiche mit einer wäßrig-alkalischen Entwicklerlösung auswäscht und die erhaltene Maske durch Erwärmen aushärtet.
